(19) Europäisches Patentamt
European Patent Office
Office européen des brevets

(11) Publication number: **0 282 201 B1**

(12) **EUROPEAN PATENT SPECIFICATION**

(45) Date of publication of patent specification: **15.06.94**

(51) Int. Cl.$^5$: **G03F 7/20**, G03F 7/09, G03F 7/105, H01L 21/00

(21) Application number: **88301564.6**

(22) Date of filing: **24.02.88**

(54) **Pattern forming method.**

(30) Priority: **09.03.87 JP 53302/87**
**07.12.87 JP 309055/87**

(43) Date of publication of application:
**14.09.88 Bulletin 88/37**

(45) Publication of the grant of the patent:
**15.06.94 Bulletin 94/24**

(84) Designated Contracting States:
**DE FR GB**

(56) References cited:
**EP-A- 0 251 241**
**WO-A-86/01313**
**DE-A- 3 248 246**
**US-A- 3 784 378**

**PATENT ABSTRACTS OF JAPAN vol. 9, no. 255 (E-349)(1978) 12 October 1985, & JP-A-60 105230**

**MICROELECTRONIC ENGINEERING. vol. 6, 1987, AMSTERDAM NL pages 495 - 501; F.A. Vollenbroek et al: "Built in Mask (BIM): A New Way to Submicron Process with High Resolution and Good Latitude"**

(73) Proprietor: **MATSUSHITA ELECTRIC INDUSTRIAL CO., LTD.**
**1006, Oaza Kadoma**
**Kadoma-shi, Osaka-fu, 571(JP)**

(72) Inventor: **Ogawa, Kazufumi**
**1-chome 30-5 Higashinakafuri**
**Hirakata Osaka 573(US)**
Inventor: **Mino, Norihisa**
**4-chome 6-8-806 Senriokahigashi**
**Settsu Osaka 566(US)**

(74) Representative: **Spencer, Graham Easdale et al**
**A.A. Thornton & CO**
**Northumberland House**
**303-306, High Holborn**
**London WC1V 7LE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

This invention relates to a pattern forming method and, more particularly to a pattern forming method for a new and simple pattern forming which is capable of providing a superfine pattern by a simple process.

The recent advancement in semiconductor device manufacturing technology has given rise to demand for photolithographic technology for forming superfine patterns in the order of 0.5 micron meter. As the technology for forming superfine patterns of 0.5 micron meter or even smaller, in the aspect of apparatus, studies of techniques for shortening the wavelength and widening the aperture of the conventional stepper are promoted. Besides, as new devices for forming superfine patterns, excimer laser steppers, X-ray steppers, and direct drawing type electron beam exposure apparatus are being developed. Moreover, various methods are proposed and attempted in the resist process technology, too. For example, multilayer resist method (MLR method), antireflective coating method (ARC method), contrast enhanced eithography method (CEL method), portable conformable mask method (PCM method), and image reversal method (IR method) are known.

There is, however, a definite limit to the widening of aperture and shortening of wavelength in the conventional stepper (i), the mask fabrication is difficult in the X-ray stepper (ii) , and the through-put is low in the direct drawing type electron beam exposure device (iii). Because of these reasons, the excimer laser stepper is presently considered to be the most hopeful one. But the excimer laser stepper has its own demerits. That is, as expressed in the following Rayleigh's equation.

$$R = k\lambda/NA \qquad (1)$$

R: resolution, k: constant (0.6 to 0.8),

λ: exposure wavelength, NA: number of apertures of lens

when it is desired to improve the resolution without changing the wavelength, the NA must be increased, but when the value of NA is increased, the focal depth (FD) becomes shallower as shown in equation (2).

$$FD = \lambda/(NA)^2 \qquad (2)$$

On the other hand, various methods are attempted, as stated above, in the resist process technology. In any of these methods, although it was effective to compensate for deterioration of focal depth in the photolithographic process, they were not practical enough because the process was complicated or the effect of expansion of focal depth was not sufficient.

That is, in the conventional resist process technology, it was not enough to cope with the shallow focal depth due to shortening of wavelength and widening of aperture in the excimer laser stepper.

It is hence a primary object of this invention, in the light of solving the above-discussed problems of the conventional resist process, to present a pattern forming method in the resist process technology capable of fully exhibiting the performance of the exposure device with a shallow focal depth as in excimer laser stepper.

An example of a process for forming a layer of patterned photoresist on a semiconductor substrate is shown in WO-A-8601313. According to this process a selected area of a thin layer of polymeric photoresist is exposed to radiation to convert it to monomeric form. The unexposed part of the photoresist is then hardened and the exposed part is removed, leaving a pattern of unexposed photoresist.

JP-A-6105230 discloses another pattern forming method in which a pattern is formed in a layer of photoresist by ion implantation, the ion implanted areas then acting as a mask in a subsequent exposure to ultraviolet radiation. Exposed parts of the photoresist are then removed leaving only the implanted areas to form the pattern.

The present invention provides a reverse process in which the portion of an organic thin film which is to form the required pattern is exposed to radiation, and the remaining part is removed.

A first aspect of the present invention provides a pattern forming method comprising:

forming an organic thin film on a substrate, the film having chemical properties which change with photochemical reactions in the vicinity of the surface of the film in response to a first light beam directed at the surface of the film; and

selectively exposing the surface of the film, according to a predetermined pattern, to said first light beam, whereby to cause said change in properties in a selected area of said film;

characterised by

the film being substantially opaque to said first light beam and substantially transparent to a second energy beam whereby said exposing step forms an area for selectively absorbing said second energy

beam on the surface of the film;

exposing the entire surface of said organic thin film to said second energy beam; and

developing the portion of the film exposed to said second energy beam excluding the portion of the film exposed to the first light beam.

In an illustrative embodiment, the organic coat film material is, for example, made of alkaline soluble resin primarily, containing, furthermore, an organic material made of aromatic azide compound which chemically changes at the wavelength of first exposure and diazo compound which chemically changes at the wavelength of second exposure.

In a second aspect, the present invention provides a pattern forming method comprising: forming an organic thin film on a substrate, the

film having chemical properties which change in the vicinity of the surface of the film in response to a first light beam directed at the surface of the film; selectively exposing the surface of the film, according to a predetermined pattern, to said first light beam, whereby to cause said change in chemical properties in a selected area of said film;

characterised by

colouring the part of the film exposed to said first light beam with a colour having a performance to shade a second energy beam;

exposing the entire surface of said organic thin film to a second energy beam with said coloured part acting as a mask; and

developing the portion of the organic film exposed to said second energy beam, excluding the areas exposed to said first light beam.

According to the present invention as described herein, the following benefits, among others are obtained.

The pattern forming method of this invention realizes the resist process making use of only the advantageous points of all of MLR, CEL, PCM, IR and other methods.

That is, for the primary energy beam exposure, for example, only the vicinity of the surface of positive resist is used, and it is exposed selectively by deep UV light (for example, KrF excimer light; 248 nm) so as to degenerate only the vicinity of surface of said resist. In the next step, the above degenerated portion is selectively stained with a chemical substance which absorbs the light of secondary energy beam exposure, for example, dyestuff. Then, the entire surface is exposed by, for example, UV light which is excellent in transmissivity to the resist as secondary energy beam, and the positive resist is developed and removed, leaving only the already stained portion. Namely, according to the resist pattern forming method of this invention;

(1) Since only the very thin portion near the surface of positive resist is selectively exposed by first exposure, the advantage of MLR is utilized.

(2) By staining the selectively exposed portion, the contact mask effect of CEL process is utilized.

(3) By selectively forming a light absorption pattern on the resist, the advantage of PCM is utilized.

(4) By forming a positive resist pattern by second full surface exposure, the effect of IR method is also utilized.

While the novel features of the invention are set forth with particularity in the appended claims, the invention, both as to organization and content, will be better understood and appreciated, along with other objects and features thereof, from the following detailed description taken in conjunction with the drawings, in which

Fig. 1 to Fig. 6 are process sectional views to explain a pattern forming method in a first embodiment of this invention; and

Fig. 7 to Fig. 11 are process sectional views to explain a pattern forming method of a second embodiment of this invention.

Referring now to Fig. 1 to Fig. 6, a first embodiment of pattern forming method and pattern forming materials of this invention is described below.

First, as shown in Fig. 1, an organic thin film 2 is formed on an arbitrary substrate (for example, a semiconductor substrate) 1 by coating with an organic coating material in a thickness of 1 to 2 microns meter. Said organic coating material is primarily composed of alkaline soluble resin (for example, phenol novolak resin), and contains, as photosensitizers, diazo compound (for example, 1,2-naphthoquinone diazide sulfonic chloride) and aromatic azide compound (for example, 2-phenylamino-5-azidebenzoic acid). In succession, as a first exposure, the vicinity of the surface of said organic thin film 2 is selectively exposed with far ultraviolet ray (for example, KrF excimer laser light) 3 (Fig. 3). Here, numeral 4 denotes a photo mask for selective exposure. At this time, since the principal component of the organic thin film 2 absorbs the majority of the far ultraviolet ray, only the surface layer in a thickness of 0.1 to 0.2 microns meter of the

organic thin film 2 is exposed in a pattern, and a very thin exposure part 5 is formed only on the surface. Therefore, in this step, the same effect as in the multilayer resist is obtained, that is, the effect is the same as when thin resists are overlaid and only the top layer resist is exposed selectively. Namely, an exposure apparatus with shallow focal depth and high resolution can be used, and a sharp superfine pattern of 0.5 micron meter or less with a high resolution can be obtained (Fig. 3).

Here, the aromatic azide compound (for example, 2-phenylamino-5-azidebenzoic acid) reacts photochemically with far ultraviolet light (for example, excimer laser light), and its color changes from green to black depending on the exposure time. That is, the extremely thin exposure part 5 of the surface only above forms a colored part 6 which is colored by said compound. At this time, the colored part 6 absorbs all light with wavelength of at least 450 nm or less (Fig. 4). Therefore, when the entire surface is exposed by using light 7 with longer wavelength than said far ultraviolet light in a second exposure, for example, light with wavelength of 450 nm or less (for instance, g-ray of 436 nm), only the uncolored portion 8 of the organic thin film 2 is selectively exposed (Fig. 5). In this step, using the colored part 6 as the mask, the uncolored part 8 which is in contact with the colored part 6 is exposed, and this is a contact exposure of so-called mask contact type. Therefore, pattern exposure of high fidelity to the mask and high precision may be performed. That is, in this step, the three effects of the CEL method, PCM method, and IR method are taken in at the same time.

Finally, by developing the organic thin film with developing solution (for example, an aqueous solution of quaternary amine compound, such as tetramethyl ammonium hydroxide), only the uncolored part 8 is removed, and the colored part 6 only is left over as resist pattern 9. Same as in the IR method, a high resolution pattern of about 0.5 micron meter opposite to the mask pattern is obtained (Fig. 6).

In this embodiment, KrF excimer laser light was used in the first exposure and g-ray as the second exposure, but the wavelengths of the first and second exposures may freely changed by the combination of light absorbing regions of the diazo compound and aromatic azide compound which are photosensitizers making up the organic coating material.

Besides, in the illustrated example, the colored part was formed selectively only on the exposed part, but, to the contrary, it is evident that the same effect is obtained, except that the pattern is inverted, when only the exposed part is decolored by causing chemical change on the colored part in the vicinity of the surface of the organic thin film by the wavelength of the first exposure, using an organic film on which a colored part is preliminarily formed entirely.

Furthermore, the light of the first exposure is not limited to excimer laser light, but X-ray, electron beam, ion beam and others may be used, and the light of the second exposure is not limited to g-ray, but i-ray, visible ray, soft X-ray and others may be used.

In the method of this embodiment, in the pattern-shaped first exposure, since only the surface portion of the organic thin film 2 is used, the exposure apparatus is widened in the aperture and shortened in the wavelength, and it is sufficiently usable if the focal depth becomes shallow, so that the resolution of the apparatus can be fully exhibited.

Furthermore, as compared with the conventional multilayer resist method (MLR method) process, only one coating step is enough, and the development is also needed in one step, so that the manufacturing process may be notably simplified.

Still more, as compared with the conventional image reverse method (IR method) process, heat treatment is not needed in the pattern forming method of this invention, so that the process stability is enhanced.

Moreover, since the pattern forming method of this embodiment does not require formation of photo bleaching film on the resist surface as required in the conventional contrast enhanced method (CEL method) process, so that the exposure time is significantly shortened, while the contrast is sufficient and coating is needed only in one step.

What is more, as compared with the conventional antireflection coating method (ARC method) process, only the vicinity of the surface of organic thin film is exposed, and the exposure light does not reach the lower part of the organic thin film, which means there is no reflection from the substrate surface, so that the pattern resolution may be notably enhanced.

In addition, the pattern forming method of this embodiment, as compared with the conventional portable conformable method (PCM method) process, is capable of forming a light absorption layer in a pattern shape of high contrast on the surface of resist without coating in two layers, so that the resolution of the resist pattern may be greatly improved. And many other effects are obtained.

Thus, the pattern forming method and pattern forming materials of this embodiment are effective to obtain a sufficiently high resolution, being applied to an exposure apparatus with shallow focal depth, such as excimer laser stepper, without making and drastic modification as compared with the conventional photo

resist process technology.

Next is explained a second embodiment of this invention by reference of the process sectional views shown in Fig. 7 to Fig. 11.

First, as shown in Fig. 7, an arbitrary substrate, for example, a semiconductor substrate (e.g. Si substrate) 10 on which a semiconductor wafer, that is, $SiO_2$ 40 is formed is coated with an ordinary positive resist 11 [for example, AZ1400, AZ4000, AZ5200 (all made by Hoechst)] in a thickness of 1 to 2 $\mu$m. Next, as a first exposure, deep UV light (far ultraviolet ray, such as KrF excimer light) 12 is selectively emitted for a short time to expose the vicinity of the surface of the positive resist 11 selectively (Fig. 8). At this time, since the main polymer of the positive resist 11 absorpts the majority of deep UV light, if slightly overexposed, the positive resist 11 is selectively exposed in a pattern shape only in the surface layer in a thickness of 0.1 to 0.2 $\mu$m, so that an extremely thin exposure pattern 20 is formed. Therefore, in this step, the same effect as in the multilayer resist, that is, lamination of thin resist layers and selective exposure of only the top layer resist, will be obtained. Namely, an exposure apparatus of shallow focal depth and high resolution can be used, and a sharp and high resolution superfine pattern 20 of 0.5 $\mu$m or less in width may be obtained.

The surface layer 20 of the positive resist selectively exposed in the above step contains, as a photosensitive material, a reagent including a

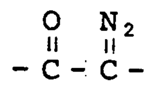

group of naphthoquinone diazide compound, and photoreaction of formula (3) occurs only by exposure.

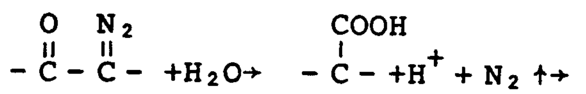 ......... (3)

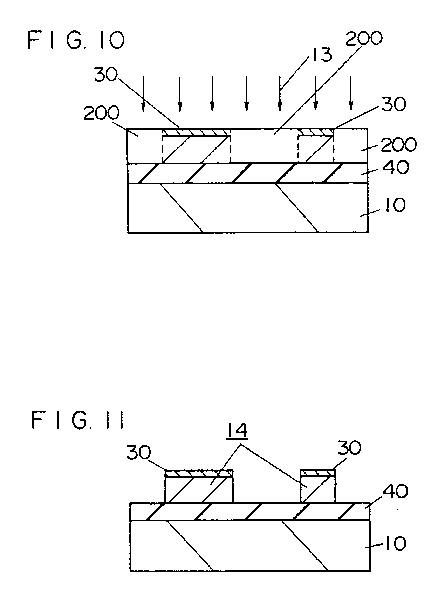

Therefore, only the -COOH group produced by this primary exposure is selectively stained with an ordinary alkaline dyestuff (such as fuchsine for red color, auramine for yellow, and aniline black for black), and a stained layer 30 is formed (Fig. 9). At this time, the alkaline dyes of red, yellow and black absorb all light with wavelength of at least 450 nm or less. Therefore, in the secondary exposure, when the entire surface is exposed by using light with longer wavelength than that of above deep UV light, for example, light 13 with wavelength of 450 nm or less, only the unstained portion 200 of the resist 11 can be selectively exposed (Fig. 10). That is, in this step, the three effects of CEL method, PCM method and IR method are taken in simultaneously.

Finally by developing with a developing solution of positive resist, only the unstained portion 200 is removed, and, same as in the IR method, a high resolution resist pattern 14 of about 0.5 $\mu$m opposite to the mask pattern may be used by using the positive resist (Fig. 11).

In this embodiment, KrF excimer light was used in the first exposure and UV light in the second exposure, but depending on the selection of resist, light of same wavelength may be used in the first and second exposures.

For pattern staining, meanwhile, alkaline dyes were used, but it is obvious that they are not limitative as far as it is possible to absorb the light of second exposure and deposit selectively on the exposure pattern part, and for example aniline may be used because it can absorb light of g-ray.

Besides, only the exposed part was selectively stained in the above illustrated example, but it is obvious that the same effects will be obtained when the other portion than the exposed part is stained except that the pattern is inverted. Similarly, the light of the first exposure is not limited to excimer laser light, by X-ray, electron beam, ion beam and others may be used, and the light of the second exposure is not limited to g-ray, but i-ray, visible ray, soft X-ray and others may be used.

Furthermore, the organic thin film is not limited to the positive resist, and any other material such as polycarbonate resin can be used as far as it can cause chemical reaction by the first energy beam and selectively deposit that substance that does not absorb or pass the second energy beam.

In this embodiment, since the pattern shaped primary exposure is used only on the resist surface, it is sufficiently usable if the exposure apparatus is higher in NA and shorter in wavelength, and shallow in the

focal depth, whereas the resolution of the apparatus can be fully exhibited.

That is, as compared with the conventional multilayer resist process (MLR method), only one step of coating is enough. To remove the resist, moreover, only one step of development is enough, and the manufacturing process may be significantly simplified.

Besides, as compared with the conventional image reversal process (IR method), since heat treatment is not needed, the process stability is excellent.

Moreover, unlike the contrast enhanced lithography method (CEL method), there is no light bleached film on the resist, and the exposure time is notably shortened, and the contrast is sufficient, and only one step of coating is enough.

What is more, as compared with the antireflection coating method (ARC method), only the vicinity of the resist surface is exposed, and the pattern exposure light does not reach to the lower part of the resist, so that there is no reflection from the substrate surface, thereby greatly enhancing the pattern resolution.

Still more, as compared with the portable conformable mask (PCM) method, it is not necessary to coat in two layers, and a pattern shaped light absorption layer of high contrast can be formed on the resist surface, so that the resist pattern may be dramatically enhanced. And many other effects are expected.

## Claims

**1.** A pattern forming method comprising:

forming an organic thin film (2) on a substrate (1), the film (2) having chemical properties which change with photochemical reactions in the vicinity of the surface of the film in response to a first light beam (3) directed at the surface of the film; and

selectively exposing the surface of the film (2), according to a predetermined pattern, to said first light beam (3), whereby to cause said change in properties in a selected area of said film;

characterised by

the film being substantially opaque to said first light beam and substantially transparent to a second energy beam whereby said exposing step forms an area (6) for selectively absorbing said second energy beam (7) on the surface of the film;

exposing the entire surface of said organic thin film (2) to said second energy beam; and developing the portion (8) of the film (2) exposed to said second energy beam (7) excluding the portion of the film exposed to the first light beam.

**2.** A pattern forming method as claimed in claim 1, wherein the organic thin film (2) is primarily composed of alkaline soluble resin, and contains an organic material which chemically changes at the wavelength of the first light beam (3) and an organic material which chemically changes at the wavelength of the second energy beam (7).

**3.** A pattern forming method as claimed in claim 2, wherein the organic material which is changed by the light of the wavelength of the first light beam (3) comprises an aromatic azide compound, and this organic material is composed of an organic material which is chemically changed by the light of the wavelength of the first light beam (3) into a substance for absorbing the wavelength region of the second energy beam (7).

**4.** A pattern forming method as claimed in claim 3, in which said aromatic azide compound is 2-phenylamino-S-azide benzoic acid.

**5.** A pattern forming method as claimed in claim 2,3 or 4, wherein the organic material which is changed by the light of the wavelength of the second energy beam (7) comprises a diazo compound.

**6.** A pattern forming method as claimed in claim 5, in which said diazo compound is 1,2-naphthoquinone diazide sulphonic chloride.

**7.** A pattern forming method as claimed in any preceding claim, wherein the wavelength of the first light beam is longer than that of the second energy beam.

**8.** A pattern forming method as claimed in any preceding claim, wherein the first and second energy beams are ultraviolet rays.

9. A pattern forming method as claimed in any preceding claim, wherein the first energy beam is deep ultraviolet excimer laser light.

10. A pattern forming method comprising: forming an organic thin film (11) on a substrate (10), the film (11) having chemical properties which change with photochemical reactions in the vicinity of the surface of the film in response to a first light beam (12) directed at the surface of the film; selectively exposing the surface of the film (10), according to a predetermined pattern, to said first light beam (12), whereby to cause said change in chemical properties in a selected area (20) of said film (10);
characterised by
colouring the part (20) of the film exposed to said first light beam (12);
exposing the entire surface of said organic thin film (11) to a second energy beam (13) with said coloured part (30) acting as a mask; and
developing the portion (200) of the organic film (11) exposed to said second energy beam (13), excluding the areas exposed to said first light beam (12).

11. A pattern forming method as claimed in claim 10, wherein said organic film containing a main polymer which absorbs the first light beam is formed by positive resist, and the coloured part is formed as being stained with a colouring material.

12. A pattern forming method as claimed in claim 10 or 11, wherein the organic thin film is a positive resist.

13. A pattern forming method as claimed in claim 10,11 or 12, wherein the substance for absorbing energy beam is a dyestuff.

14. A pattern forming method as claimed in claim 13, wherein the dyestuff is an alkaline dyestuff.

15. A pattern forming method as claimed in claim 10, 11,12 or 13, wherein the positive resist contains a

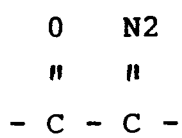

group.

**Patentansprüche**

1. Ein Verfahren zur Herstellung von Mustern, umfassend:
Bilden einer organischen, dünnen Schicht (2) auf einem Substrat (1), wobei die Schicht (2) chemische Eigenschaften aufweist, die sich mit fotochemischen Reaktionen in der Nähe der Oberfläche der Schicht in Reaktion auf ein erstes Lichtstrahlenbündel (3) ändern, das auf die Oberfläche der Schicht gerichtet ist; und
selektives Aussetzen der Oberfläche der Schicht (2) gemäß einem vorbestimmten Muster dem genannten ersten Lichtstrahlenbündel (3), wodurch die genannte Änderung der Eigenschaften in einem ausgewählten Bereich der genannten Schicht hervorgerufen wird; **dadurch gekennzeichnet,** daß
die Schicht vollständig lichtundurchlässig für das genannte erste Lichtstrahlenbündel und im wesentlichen transparent für ein zweites Energiestrahlenbündel ist, wodurch der genannte Belichtungsschritt einen Bereich (6) zum selektiven Absorbieren des genannten zweiten Energiestrahlenbündel (7) auf der Oberfläche der Schicht bildet;
die gesamte Oberfläche der genannten organischen, dünnen Schicht (2) dem genannten zweiten Energiestrahlenbündel ausgesetzt wird; und der Bereich (8) der Schicht (2), die dem genannten zweiten Energiestrahlenbündel (7) ausgesetzt worden ist, entwickelt wird, wobei der Bereich, der dem ersten Lichtstrahlenbündel ausgesetzt worden war, ausgeschlossen wird.

2. Ein Verfahren zur Herstellung von Mustern, wie es in Anspruch 1 beansprucht ist, bei dem die organische, dünne Schicht (2) hauptsächlich aus einem alkalisch lösbaren Kunststoff gebildet ist und einen organischen Stoff enthält, der sich chemisch bei der Wellenlänge des ersten Lichtstrahlenbündels (3) ändert, und einen organischen Stoff, der sich chemisch bei der Wellenlänge des zweiten Energiestrahlenbündels (7) ändert.

**3.** Ein Verfahren zur Herstellung von Mustern, wie es in Anspruch 2 beansprucht ist, bei dem der organische Stoff, der durch das Licht mit der Wellenlänge des ersten Lichtstrahlenbündels (3) geändert wird, eine aromatische Azidverbindung umfaßt, und dieser organische Stoff aus einem organischen Stoff gebildet ist, der durch das Licht der Wellenlänge des ersten Lichtstrahlenbündels (3) in einen Stoff zum Absorbieren des Wellenlängenbereiches des zweiten Energiestrahlenbündels (7) umgeändert wird.

**4.** Ein Verfahren zur Herstellung von Mustern, wie es in Anspruch 3 beansprucht ist, bei dem die genannte aromatische Azidverbindung 2-Pheylamino-5-Azidbenzoesäure ist.

**5.** Ein Verfahren zur Herstellung von Mustern, wie es in Anspruch 2, 3 oder 4 beansprucht ist, bei dem das organische Material, das durch das Licht der Wellenlänge des zweiten Energiestrahlenbündels (7) geändert wird, eine Diazoverbindung umfaßt.

**6.** Ein Verfahren zur Herstellung von Mustern, wie es in Anspruch 5 beansprucht ist, bei dem die genannte Diazoverbindung 1,2-Naphthoquinondiazidsulfochlorid ist.

**7.** Ein Verfahren zur Herstellung von Mustern, wie es in irgendeinem vorhergehenden Anspruch beansprucht ist, bei dem die Wellenlänge des ersten Lichtstrahlenbündel länger als diejenige des zweiten Energiestrahlenbündels ist.

**8.** Ein Verfahren zur Herstellung von Mustern, wie es in irgendeinem vorhergehenden Anspruch beansprucht ist, bei dem das erste und das zweite Energiestrahlenbündel Ultraviolettstrahlen sind.

**9.** Ein Verfahren zur Herstellung von Mustern, wie es in irgendeinem vorhergehenden Anspruch beansprucht ist, bei dem das erste Energiestrahlenbündel kurzes, ultraviolettes Excimer-Laserlicht ist.

**10.** Ein Verfahren zur Herstellung von Mustern, umfassend:
Bilden einer organischen, dünnen Schicht (11) auf einem Substrat (10), wobei die Schicht (11) chemische Eigenschaften aufweist, die sich mit fotochemischen Reaktionen in der Nähe der Oberfläche der Schicht in Reaktion auf ein erstes Lichtstrahlenbündel (12) ändern, das auf die Oberfläche der Schicht gerichtet ist; und selektives Aussetzen der Oberfläche der Schicht (10) gemäß einem vorbestimmten Muster dem genannten ersten Lichtstrahlenbündel (12), wodurch die genannte Änderung der Eigenschaften in einem ausgewählten Bereich (20) der genannten Schicht (10) hervorgerufen wird;
**gekennzeichnet durch**
Färben des Teils in (20) der dem genannten ersten Lichtstrahlenbündel (12) ausgesetzten Schicht; Aussetzen der gesamten Oberfläche der genannten organischen, dünnen Schicht (11) einem zweiten Energiestrahlenbündel (13), wobei der genannte gefärbte Teil (30) als eine Maske wirkt; und
Entwickeln des Bereiches (200) der organischen Schicht (11), die dem genannten zweiten Energiestrahlenbündel (13) ausgesetzt worden war, wobei die dem genannten ersten Lichtstrahlenbündel (12) ausgesetzten Bereiche ausgeschlossen werden.

**11.** Ein Verfahren zur Herstellung von Mustern, wie es in Anspruch 10 beansprucht ist, bei dem die genannte organische Schicht, die ein Hauptpolymer enthält, das das erste Lichtstrahlenbündel absorbiert, durch positiven Resist gebildet ist, und der gefärbte Teil gebildet wird, indem er mit einem Farbstoff gefärbt wird.

**12.** Ein Verfahren zur Herstellung von Mustern, wie es in Anspruch 10 oder 11 beansprucht ist, bei dem die organische, dünne Schicht ein positiver Resist ist.

**13.** Ein Verfahren zur Herstellung von Mustern, wie es in Anspruch 10, 11 oder 12 beansprucht ist, bei dem der Stoff zum Absorbieren des Energiestrahlenbündels ein Farbstoff ist.

**14.** Ein Verfahren zur Herstellung von Mustern, wie es in Anspruch 13 beansprucht ist, bei dem der Farbstoff ein alkalischer Farbstoff ist.

**15.** Ein Verfahren zur Herstellung von Mustern, wie es in Anspruch 10, 11, 12 oder 13 beansprucht ist, bei dem der positive Resist eine

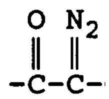

Gruppe enthält.

## Revendications

**1.** Procédé de formation d'un motif, comprenant :

la formation d'un film organique mince (2) sur un substrat (1), le film (2) ayant des propriétés chimiques qui changent avec les réactions photochimiques du voisinage de la surface du film sous l'action d'un premier faisceau lumineux (3) dirigé à la surface du film, et

l'exposition sélective de la surface du film (2), avec un motif prédéterminé, au premier faisceau lumineux (3), de manière que le changement de propriétés soit provoqué dans une zone choisie du film,

caractérisé en ce que

le film est pratiquement opaque au premier faisceau lumineux et pratiquement transparent au second faisceau d'énergie, si bien que l'étape d'exposition forme une zone (6) d'absorption sélective du second faisceau d'énergie (7) à la surface du film,

toute la surface du film organique mince (2) est exposée au second faisceau d'énergie, et

la partie (8) du film (2) exposée au second faisceau d'énergie (7) est développée à l'exclusion de la partie du film exposée au premier faisceau lumineux.

**2.** Procédé de formation d'un motif selon la revendication 1, dans lequel le film organique mince (2) est essentiellement composé d'une résine soluble dans une matière alcaline, et contient une matière organique qui change chimiquement à la longueur d'onde du premier faisceau lumineux (3) et une matière organique qui change chimiquement à la longueur d'onde du second faisceau d'énergie (7).

**3.** Procédé de formation d'un motif selon la revendication 2, dans lequel la matière organique qui est changée par la lumière à la longueur d'onde du premier faisceau lumineux (3) contient un composé d'azide aromatique et cette matière organique est composée d'une matière organique qui est modifiée chimiquement par la lumière à la longueur d'onde du premier faisceau lumineux (3) en une substance assurant l'absorption de la région des longueurs d'onde du second faisceau d'énergie (7).

**4.** Procédé de formation d'un motif selon la revendication 3, dans lequel le composé d'azide aromatique est l'acide 2-phénylamino-S-azidebenzoïque.

**5.** Procédé de formation d'un motif selon la revendication 2, 3 ou 4, dans lequel la matière organique qui est changée par la lumière à la longueur d'onde du second faisceau d'énergie (7) est un composé diazoïque.

**6.** Procédé de formation d'un motif selon la revendication 5, dans lequel le composé diazoïque est le chlorure sulfonique de 1,2-naphtoquinonediazide.

**7.** Procédé de formation d'un motif selon l'une quelconque des revendications précédentes, dans lequel la longueur d'onde du premier faisceau lumineux est supérieure à celle du second faisceau d'énergie.

**8.** Procédé de formation d'un motif selon l'une quelconque des revendications précédentes, dans lequel le premier et le second faisceau d'énergie sont des rayonnements ultraviolets.

**9.** Procédé de formation d'un motif selon l'une quelconque des revendications précédentes, dans lequel le premier faisceau d'énergie est la lumière d'un laser à excimère dans l'ultraviolet lointain.

**10.** Procédé de formation d'un motif comprenant :

la formation d'un film organique mince (11) sur un substrat (10), le film (11) ayant des propriétés chimiques qui changent avec les réactions chimiques au voisinage de la surface du film sous l'action d'un premier faisceau lumineux (12) dirigé à la surface du film, et

l'exposition sélective de la surface du film (10), suivant un motif prédéterminé, par le premier faisceau lumineux (12) afin que le changement de propriétés chimiques soit provoqué dans une zone choisie (20) du film (10),

caractérisé par

la coloration de la partie (20) du film exposée au premier faisceau lumineux (12),

l'exposition de toute la surface du film organique mince (11) à un second faisceau d'énergie (13) avec la partie colorée (30) agissant comme masque, et

le développement de la partie (200) du film organique (11) exposée au second faisceau d'énergie (13), à l'exclusion des zones exposées au premier faisceau lumineux (12).

**11.** Procédé de formation d'un motif selon la revendication 10, dans lequel le film organique contenant un polymère principal qui absorbe le premier faisceau lumineux est formé d'une matière de réserve positive, et la partie colorée est formée par imprégnation par une matière de coloration.

**12.** Procédé de formation d'un motif selon la revendication 10 ou 11, dans lequel le film organique mince est une matière de réserve positive,

**13.** Procédé de formation d'un motif selon la revendication 10, 11 ou 12, dans lequel la substance qui absorbe le faisceau d'énergie est un colorant.

**14.** Procédé de formation d'un motif selon la revendication 13, dans lequel le colorant est un colorant alcalin.

**15.** Procédé de formation d'un motif selon la revendication 10, 11, 12 ou 13, dans lequel la matière de réserve contient un groupe

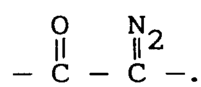

FIG. 1

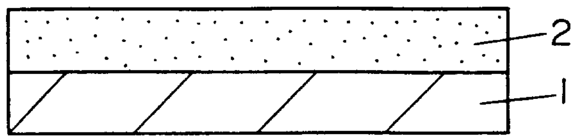


FIG. 2

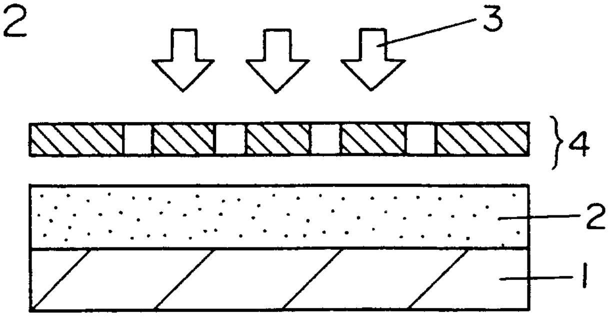


FIG. 3

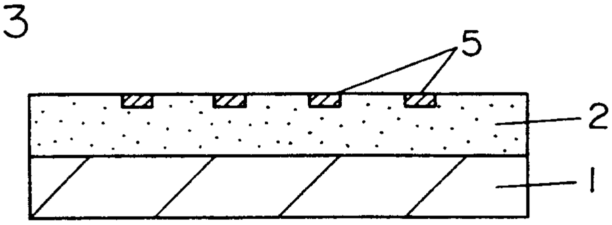


FIG. 4

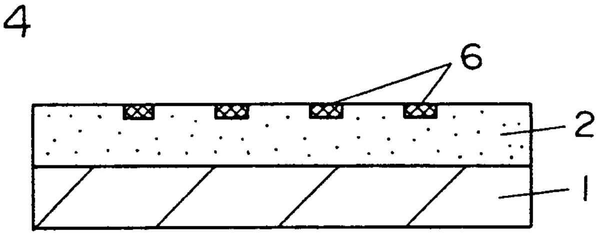


FIG. 5

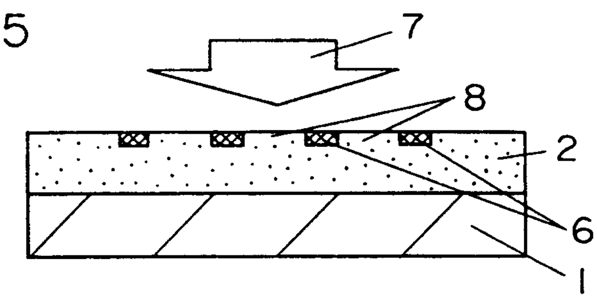

FIG. 6

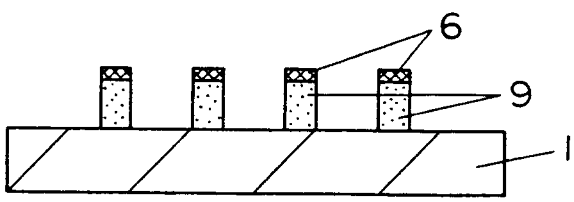


FIG. 7

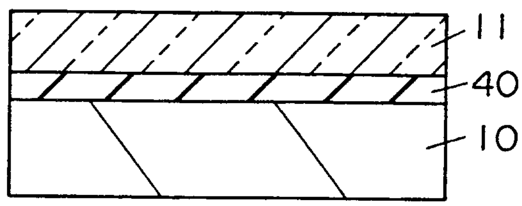


FIG. 8

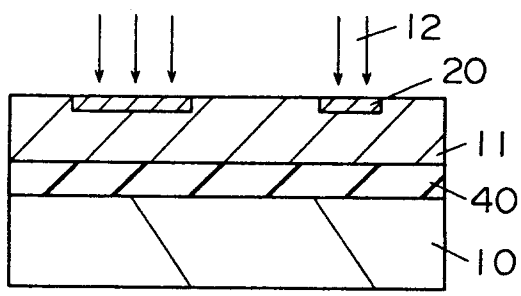


FIG. 9

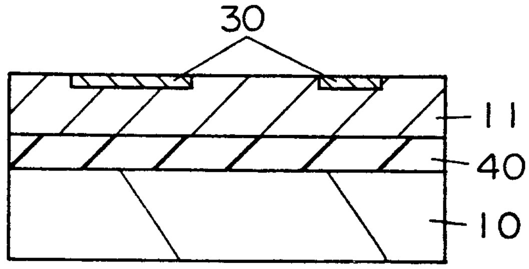

FIG. 10

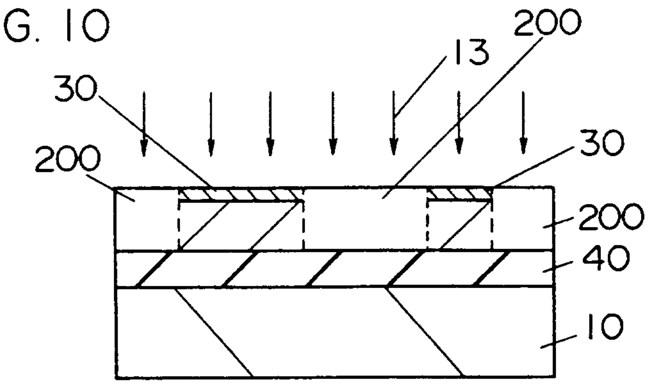


FIG. 11